Europäisches Patentamt

European Patent Office

Office européen des brevets

(19)

(11) Veröffentlichungsnummer: **0 361 319**
**A2**

## EUROPÄISCHE PATENTANMELDUNG

(21) Anmeldenummer: **89117501.0**

(22) Anmeldetag: **21.09.89**

(51) Int. Cl.⁵: **H01L 29/06**

(30) Priorität: **27.09.88 DE 3832750**

(43) Veröffentlichungstag der Anmeldung:
**04.04.90 Patentblatt 90/14**

(84) Benannte Vertragsstaaten:
**DE FR GB IT**

(71) Anmelder: **Asea Brown Boveri**
**Aktiengesellschaft**
**Kallstadter Strasse 1**
**D-6800 Mannheim 31(DE)**

(72) Erfinder: **Langer, Kurt, Dr.**
**Kiefernweg 8**
**D-6909 Walldorf(DE)**

(74) Vertreter: **Rupprecht, Klaus, Dipl.-Ing. et al**
**c/o Asea Brown Boveri Aktiengesellschaft**
**Zentralbereich Patente Postfach 100351**
**D-6800 Mannheim 1(DE)**

(54) **Leistungshalbleiterbauelement.**

(57) Bei einem Leistungshalbleiterbauelement mit planarem Randabschluß durch Feldringe ist die Aufgabe gestellt, auf platzsparende Weise möglichst 100% der Volumendurchbruchspannung zu erzielen.

Diese Aufgabe wird dadurch gelöst, daß sowohl der Randbereich (9) des Hauptübergangs als auch Feldringe (8) in einem gesonderten Diffusionsprozeß hergestellt werden, wodurch ein vom aktiven Teil des Bauelements abweichendes Dotierungsprofil eingestellt werden kann.

Die Erfindung kann besonders vorteilhaft bei schnellen Dioden, auch epitaktischen Bauelementen angewendet werden.

Fig 1

EP 0 361 319 A2

## Leistungshalbleiterbauelement

Die Erfindung bezieht sich auf ein Leistungshalbleiterbauelement nach dem Oberbegriff des Anspruchs 1.

Solche Leistungshalbleiterbauelemente mit einem planaren Randabschluß der durch ein System von feldbegrenzenden Ringen mit einer Passivierungsschicht gebildet wird, sind beispielsweise aus Proceedings of the IEEE Vol. 55, Nr. 8, Aug. 1967, Seite 1409 bis 1414, insbesondere Fig. 5 bekannt. Im Vergleich zu anderen Lösungsmöglichkeiten für den Randabschluß, bei denen eine Randkonturierung durch Gräben oder Anschrängungen vorgesehen sind, bieten planare Randabschlüsse prozeßtechnische Vorteile. Je nach Anzahl und Anordnung der Feldringe kann eine Sperrspannung realisiert werden, die nahe an die theoretisch mögliche Sperrspannung herankommt, die durch die Volumendurchbruchspannung, also durch die Dimensionierung des Bauelementes im Inneren bestimmt ist, jedoch diese nicht ganz erreicht.

Die Feldringe, die auch als Guard-Ringe bezeichnet werden, umschließen als konzentrische Ringe, die in einem Abstand zueinander angeordnet sind, die aktive Fläche des Halbleiterbauelements, z.B. den anodenseitigen Emitter, und zwar ebenfalls in einem Abstand zu diesem.

Diese Feldringe können als sogenannte floatende Guard-Ringe isoliert angeordnet sein, d.h. sie sind im Potential floatend oder sie können über Widerstandsschichten an der Oberfläche untereinander und mit dem Hauptübergang verbunden sein. Zur weiteren Sperrspannungserhöhung kann das Feldringsystem auch mit sogenannten Feldplatten kombiniert werden.

Bei der Herstellung eines Halbleiterbauelementes geht man von einem Substrat eines ersten Leitfähigkeitstyps, z.B. einem n-leitenden Subtrat aus, und diffundiert in eine erste Hauptfläche einen Dotierungsstoff zur Herstellung einer Schicht eines zweiten, z.B. p-leitenden Typs und damit eines sperrenden pn-Übergangs für den aktiven Teil des Bauelements. Dabei werden die Feldringe in einem Masken- und einem Diffusionsschritt gleichzeitig mit der p-leitenden Schicht des aktiven Teils, d.h. des anodenseitigen Emitters des Bauelements, hergestellt. Dadurch ist die Justierung der Ringe gegenüber dem Hauptübergang, also dem sperrenden pn-Übergang sichergestellt.

Die beschriebene Herstellungsweise, wonach die Feldringe gleichzeitig mit der p-leitenden Schicht des aktiven Teils hergestellt werden, hat zur Folge, daß die Ringe das gleiche Dotierungsprofil wie der sperrende pn-Übergang aufweisen. Kennzeichnend für den beschriebenen bekannten Randabschluß ist auch, daß die höchste Feldstärke im Randbereich auftritt, d.h. das Feldmaximum liegt entweder an der Randkrümmung des Hauptübergangs oder an einem der Guardringe.

Die Diffusionstiefe der Ringe könnte man beeinflussen durch die Wahl von sehr kleinen Maskenöffnungen, wodurch kleinere Ladungsmengen eindiffundiert würden. Dadurch ließe sich zwar des Platzbedarf für die Feldringe etwas reduzierten, jodoch wäre damit kein Vorteil hinsichtlich der Sperrspannung gegeben.

Die Platzbedarf hängt von der Anzahl der Ringe ab, die wiederum abhängt von der verlangten Sperrspannung, also dem gewünschten Anteil der Volumendurchbruchspannung. Die notwendige Anzahl der Ringe ist somit auch stark abhängig vom Dotierungsprofil des sperrenden pn-Übergangs. Das bedeutet, wenn aus Gründen, die andere Eigenschaften des Bauelements betreffen, eine geringe Tiefe des sperrenden Übergangs, beispielsweise von 5 bis 10 μm gefordert wird, eine große Zahl von Ringen, ggf. mehr als 10, mit entsprechendem Platzbedarf erforderlich ist.

Eine Anordnung von feldbegrenzenden Ringen ist auch aus Ghandhi, I. K., Semiconductor Power Devices, Verlag Wiley & Sons, New York, 1977, Kapitel 2, Seite 64, Fig. 2.18 bekannt. Außerdem ist in Fig. 2.17 dieser Veröffentlichung noch eine andere Möglichkeit dargestellt, eine hohe Sperrspannung zu erzielen. Es wird dort eine Avalanche-Diode angegeben, wobei in ein p-leitendes Substrat eine $n^+$-leitende Schicht diffundiert ist, die aus einem flachen $n^+$-Hauptgebiet besteht, das in einen tiefen $n^+$-Ring übergeht. Eine solche Maßnahme zur Minderung der Feldstärke an der Oberfläche mag für einige spezielle Bauelemente ausreichend sein, ist jedoch nicht generell als Randabschluß für Leistungshalbleiterhauelemente geeignet. Der pn-Übergang müßte nämlich im Randbereich sehr tief sein, was zu extrem langen Diffusionszeiten führen würde und einem großen Abstand zwischen Anode und Kathode erforderlich macht und somit zu einem großen Durchlaßspannungsabfall führt. Eine denkbare Maßnahme zur Minderung des Durchlaßspannungsabfalls wäre eine strukturierte tiefe Diffusion auf der Kathodenseite, was aber beispielsweise bei EPI-Bauelementen nicht möglich wäre.

Die Erfindung geht von Leistungshalbleiterbauelementen mit einem planaren Randabschluß mit Feldringen aus, wobei die Aufgabe besteht, möglichst 100% der Volumendurchbruchspannung als Sperrspannung zu erzielen und trotzdem den Platzbedarf für den Randabschluß kleinzuhalten.

Diese Aufgabe wird bei einem Leistungshalbleiterbauelement nach dem Oberbegriff des Anspruchs 1 durch dessen kennzeichnende Merkmale gelöst.

Vorteilhafte Ausgestaltungen sind in Untersprüchen angegeben.

Mit der Erfindung wird vorgeschlagen, eine Diffusion des sperrenden pn-Übergangs in zwei getrennten Diffusions-schritten durchzuführen. Dadurch kann der eigentliche aktive Bereich hinsichtlich dynamischer Eigenschaften des Bauelements optimiert werden, ohne auf Probleme des Sperrens Rücksicht nehmen zu müssen. Jedenfalls ergibt sich ein relativ großer Bereich, in dem die dynamischen und statischen Eigenschaften des Hauptübergangs ohne wesentliche Einschränkungen durch den Randabschluß optimiert werden können. Der für die Sperrspannung wesentliche Randbereich wird praktisch allein im Hinblick auf die Sperrspannung optimiert. Das bedeutet, daß für den Randbereich eine größere Eindringtiefe gewählt werden kann, als für den übrigen aktiven pn-Übergang und daß ein anderes Dotierstoffprofil gewählt werden kann. Das Profil für den Randbereich und für die im gleichen Diffusionsprozeß hergestellten Feldringe kann also insgesamt sehr verschieden sein von demjenigen des aktiven Teils des pn-Übergangs. Dies ist besonders vorteilhaft bei schnellen Dioden für 500 bis 1000V Sperrspannung, die im aktiven Teil des pn-Übergangs eine geringe Eindringtiefe der $p^+$-Zone und damit ein steiles Dotierstoffprofil aufweisen. Auf vorteilhafte Weise kann bereits mit wenigen Feldringen, also platzsparend, eine Sperrspannung erreicht werden, die 100% der Volumendurchbruchspannung entspricht. Die Erfindung ist nicht auf eine Anwendung bei Dioden begrenzt, sondern kann grundsätzlich auch bei Thyristoren und Transistoren zur Anwendung kommen. Sie ist auch bei Bauelementen auf epitaktischem Material anwendbar.

Wie beispielsweise aus White and Coe, Numerical Analysis of multiple Field limiting Ring Systems, Solid State Electronics, Vol. 27, No. 11, Seiten 1021 bis 1027, 1984 bekannt ist, verhindern floatende Guard-Ringe in recht erheblichem Maße ein Absinken der Sperrspannung bei positiven Oberflächenladungen, die bei Standardprozessen, insbesondere bei Oxidabdeckung nie ganz zu vermeiden sind. Der Erfinder hat mit eigenen Rechnungen festgestellt, daß diese in der Praxis wichtige Eigenschaft bis zu Ladungsdichten von mindestens $2 \cdot 10^{11} cm^{-2}$ auch bei den erfindungsgemäßen tiefen Ringen erhalten bleibt.

Anhand eines in der Zeichnung dargestellten Ausführungsbeispiels wird die Erfindung näher erläutert.

Es zeigt:

Fig. 1 einen Querschnitt durch den Randbereich einer erfindungsgemäßen Diode,

Fig. 2 Dotierungsprofile des Hauptübergangs im Volumen und am Rand und

Fig. 3 das Ergebnis einer Rechnersimulation zur Feldstärkeverteilung im Randbereich der in Fig. 1 dargestellten Diode.

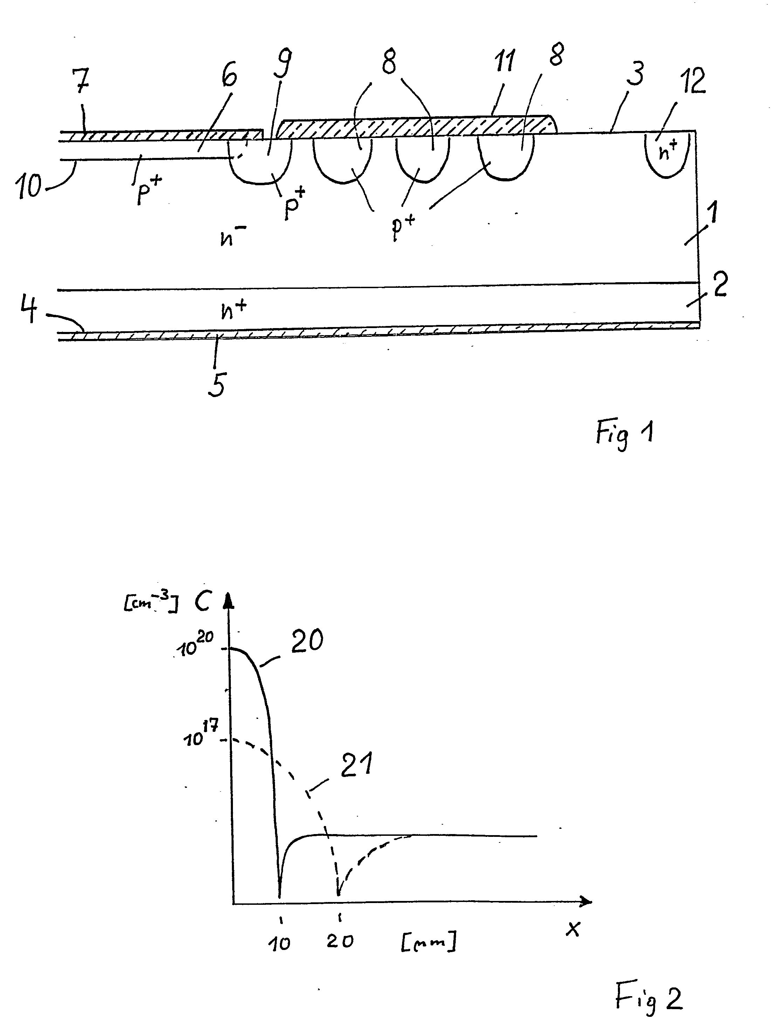

Fig. 1 zeigt einen Querschnitt durch den Randbereich einer Diode. Die Diode weist übliche Schichten eines n-leitenden ersten Leitungstyps und eines p-leitenden zweiten Leitungstyps auf. Sie besteht aus einem schwachdotierten Substrat des ersten Leitungstyps, also einem $n^-$-Substrat 1, das kathodenseitig verstärkt dotiert ist, zur Bildung einer $n^+$-Schicht 2, die eine Kathodenmetallisierung 5 trägt. Die Oberfläche der $n^+$-Schicht 2 ist als zweite Hauptfläche 4 bezeichnet. Als erste Hauptfläche 3 ist die anodenseitige Oberfläche bezeichnet. In die Hauptfläche 3 ist eine $p^+$-leitende Schicht 6 diffundiert, auf die eine Anodenmetallisierung 7 aufgebracht ist. Die $p^+$-leitende Schicht bildet mit der $n^-$-Schicht 1 in üblicher Weise einen sperrenden pn-Übergang 10 als Hauptübergang. Im Hinblick auf ein schnelles Schalten der Diode ist nur eine geringe Eindringtiefe der $p^+$-Schicht 6 von etwa 5 bis 10 μm vorgesehen und eine hohe Oberflächenkonzentration, also z.B. eine Dotierstoffkonzentration von $10^{20} cm^{-3}$. Ein damitgegebenes typisches Profil des Hauptübergangs 10 ist in Fig. 2 als Linienzug 20 dargestellt.

In einem gesonderten Diffusionsprozeß, der in der Praxis als erster Diffusionsprozeß durchgeführt wird, sind vier konzentrische $p^+$-leitende Ringe in die Hauptfläche 3 diffundiert, wovon die äußeren drei Ringe Feldringe 8 sind und der innere Ring, der sich etwas mit der $p^+$-Schicht 6 überschneidet, einen Randbereich 9 der $p^+$-Schicht bildet. In Fig. 2 ist als gestrichelter Linienzug 21 das Profil des Randbereichs 9 des pn-Übergangs dargestellt, das in gleicher Weise für die Feldringe 8 gilt. Dieses Profil 21 unterscheidet sich durch geringere Konzentration C und größere Eindringtiefe x vom Profil 20 des Hauptübergangs. In Fig. 2 sind beispielhaft Werte für die Konzentration C und die Eindringtiefe x eingetragen.

Die Stelle, an der der pn-Übergang des Randbereichs 9 an die Oberfläche 3 tritt, und auch die Feldringe 8 sind mit einer Passivierungsschicht 11 abgedeckt. Außerdem ist das Bauelement durch einen in die Oberfläche 3 diffundierten Ring vom $n^+$-Typ, also einen sogenannten channel stopper 12 in bekannter Weise begrenzt.

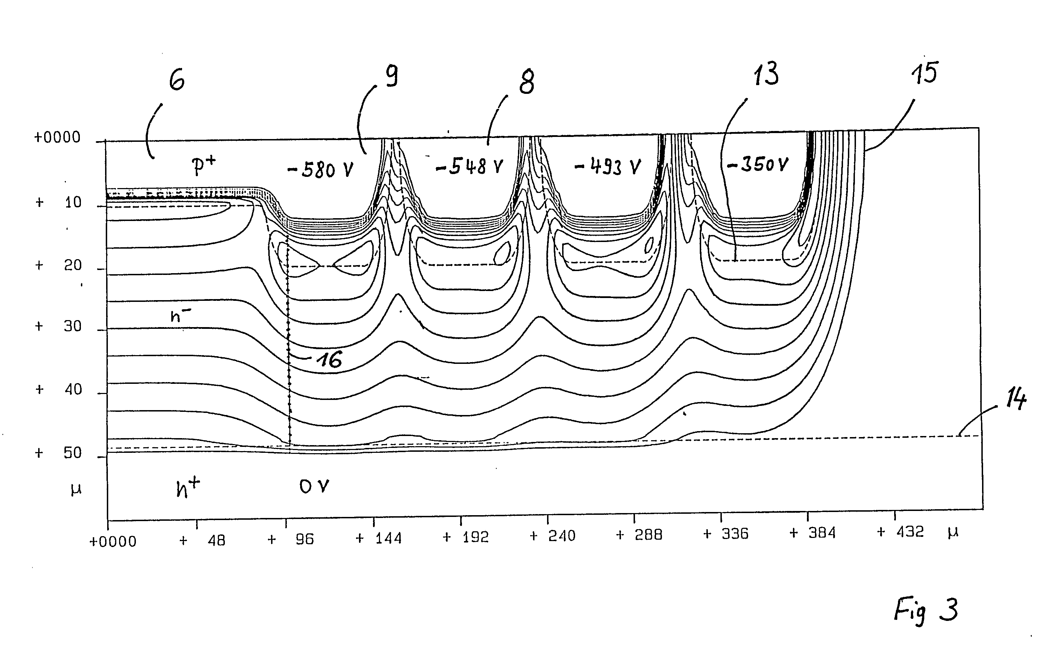

Fig. 3 zeigt des Ergebnis einer Simultationsrechnung für eine 500V-Diode, bei der bereitsmit drei floatenden Ringen die Volumendurchbruchsspannung zu 100% erreicht wird. Dargestellt ist die Feldverteilung in einem Rechengebiet, das sich auf das hier interessierende Randgebiet der Diode bezieht. Im oberen Bereich der Abbildung ist die $p^+$-leitende Schicht mit geringer Eindringtiefe zu erkennen, die übergeht in den tiefer diffundierten Randbereich 9, sowie die drei Feldringe 8. Die zugehörigen $p^+n^-$-Übergänge sind im oberen Bereich der Fig. 3 durch gestrichelte Linien 13 dargestellt. Ein $n^-n^+$-Übergang ist in einem unteren Bereich als gestrichelte Linie 14 eingezeichnet. Die durchgezogenen Linien 15 verbinden Orte gleichen Feldstärkebetrages. Eine gepunktete Linie 16 zeigt den Weg höchster Beschleunigung der Ladungsträger in Richtung auf das Feldmaximum. Hier sind die Feldmaxima an den Ringen 8 deutlich kleiner als das Maximum am Hauptübergang. Das eigentliche Maximum am Randbereich 9 unterscheidet sich vom Feldmaximum am Hauptübergang 6 um weniger als 1%, so daß praktisch die Volumensperrspannung erreicht wird. Damit ist nachgewiesen, daß die gestellte Aufgabe mit den vorgeschlagenen Maßnahmen gelöst werden kann.

**Ansprüche**

1. Leistungshalbleiterbauelement mit
- einer ersten und einer zweiten Hauptfläche,
- wenigsten einer ersten Schicht eines ersten Leitungstyps, z.B. n-leitenden Typs, die an die zweite Hauptfläche angrenzt, und wenigstens einer zweiten Schicht eines zweiten Leitungstpys, z.B. p-leitenden Typs,
- einem pn-Übergang zwischen der ersten und der zweiten Schicht, wobei der pn-Übergang an der ersten Hauptfläche an die Oberfläche tritt, und einem planaren Randabschluß, der durch Feldringe gebildet ist, die an die erste Hauptfläche grenzen, dadurch gekennzeichnet, daß die Feldringe (8) und ein Randbereich (9) der zweiten Schicht (6) in einem zuzätzlichen Diffusionsprozeß hergestellt sind, wobei die Do tierstoffkonzentration des Randbereichs (9) und der Feldringe (8) an der Oberfläche geringer ist als die Oberflächenkonzentration der zweiten Schicht (6) in ihrem Hauptbereich.

2. Leistungshalbleiterbauelement nach Anspruch 1, dadurch gekennzeichnet, daß die Feldringe (8) und der Randbereich (9) tiefer diffundiert sind als die erste Schicht in ihrem Hauptbereich (6).

3. Leistungshalbleiterbauelement nach Anspruch 1 oder 2, dadurch gekennzeichnet, daß die Feldringe (8) sogenannte floatende Feldringe sind, die nicht durch leitende Schichten gekoppelt sind.

4. Leistungshalbleiterbauelement nach einem der Ansprüche 1 bis 3, dadurch gekennzeichnet, daß das Leistungshalbleiterbauelement eine Diode ist.

5. Leistungshalbleiterbauelement nach einem der Ansprüche 1 bis 4, dadurch gekennzeichnet, daß als Passivierungsschicht (11) ein Passivierungsglas verwendet ist.

6. Leistungshalbleiterbauelement nach einem der Ansprüche 1 bis 4, dadurch gekennzeichnet, daß als Passivierungsschicht (11) eine aus mehreren Einzelschichten zusammenges`etzte Schicht vorgesehen ist.

Fig 1

Fig 2

Fig 3